(19) **Europäisches Patentamt**
**European Patent Office**
**Office européen des brevets**

(11) **EP 2 050 515 B1**

(12) **EUROPEAN PATENT SPECIFICATION**

(45) Date of publication and mention
of the grant of the patent:
**27.02.2013 Bulletin 2013/09**

(51) Int Cl.:
*B08B 1/00* (2006.01)  *B08B 7/00* (2006.01)
*C23C 16/44* (2006.01)  *H01L 21/67* (2006.01)

(21) Application number: **07767769.8**

(22) Date of filing: **28.06.2007**

(86) International application number:
**PCT/JP2007/062975**

(87) International publication number:
**WO 2008/018251 (14.02.2008 Gazette 2008/07)**

(54) **CLEANING MEMBER, DELIVERY MEMBER WITH CLEANING FUNCTION, AND METHOD OF CLEANING SUBSTRATE PROCESSING APPARATUS**

REINIGUNGSGLIED, ZUFUHRGLIED MIT REINIGUNGSFUNKTION UND VERFAHREN ZUR REINIGUNG EINER SUBSTRATVERARBEITUNGSVORRICHTUNG

ÉLÉMENT DE NETTOYAGE, ÉLÉMENT DE DISTRIBUTION AVEC FONCTION DE NETTOYAGE, ET PROCÉDÉ DE NETTOYAGE D'UN APPAREIL DE TRAITEMENT DE SUBSTRAT

(84) Designated Contracting States:
**DE FR NL**

(30) Priority: **11.08.2006 JP 2006219435**

(43) Date of publication of application:
**22.04.2009 Bulletin 2009/17**

(73) Proprietor: **Nitto Denko Corporation**
**Ibaraki-shi,**
**Osaka 567-8680 (JP)**

(72) Inventors:
• **SUGO, Yuki**
**Ibaraki-shi, Osaka 5678680 (JP)**
• **TERADA, Yoshio**
**Ibaraki-shi, Osaka 5678680 (JP)**
• **UENDA, Daisuke**
**Ibaraki-shi, Osaka 5678680 (JP)**
• **NAMIKAWA, Makoto**
**Ibaraki-shi, Osaka 5678680 (JP)**
• **YOSHIDA, Yoshinori**
**Ibaraki-shi, Osaka 5678680 (JP)**
• **MAENO, Youhei**
**Ibaraki-shi, Osaka 5678680 (JP)**

(74) Representative: **Ilgart, Jean-Christophe et al**
**BREVALEX**
**95 rue d'Amsterdam**
**75378 Paris Cedex 8 (FR)**

(56) References cited:
**WO-A1-2005/018879    JP-A- 2001 351 960**
**JP-A- 2004 063 669    JP-A- 2004 063 669**
**US-A1- 2003 049 407    US-A1- 2003 124 935**

**Description**

**TECHNICAL FIELD**

The present invention relates to a cleaning member for removing minute foreign matter, a delivery member provided with a cleaning function, and a method of cleaning a substrate processing apparatus with use of the delivery member provided with a cleaning function. More specifically, the present invention relates to a cleaning member for removing minute foreign matter from a substrate and an apparatus that has an aversion to the foreign matter, such as a semiconductor, a flat panel display, a printed board, and a substrate processing apparatus, a delivery member provided with a cleaning function having the cleaning member, and a method of cleaning a substrate processing apparatus with the use of the delivery member provided with a cleaning function.

**BACKGROUND ART**

In various kinds of substrate processing apparatuses and the like that have an aversion to foreign matter, such as a production apparatus and inspection apparatus of a semiconductor, a flat panel display, a printed board, and the like, each transfer system and a substrate are transferred while they are brought into contact with each other. In this case, when the foreign matter adheres to the substrate and the transfer system, the subsequent substrates are contaminated one after another, and hence it is necessary to stop the apparatus periodically so as to clean the apparatus. As a result, there arise problems in that the operation rate of the substrate processing apparatus decreases, and that a great amount of labor is required for cleaning the substrate processing apparatus.

In order to solve such problems described above, a method of removing foreign matter adhering to the back surface of a substrate by transferring a plate-shaped member has been proposed (see Patent Document 1). According to the method, it is not necessary to stop a substrate processing apparatus so as to clean the substrate processing apparatus, and hence the problem of decrease in the operation rate of the substrate processing apparatus is solved. However, according to the method, minute foreign matters cannot be removed sufficiently.

On the other hand, a method of cleaning and removing foreign matter adhering to the inside of the substrate processing apparatus by transferring a substrate with an adherent material adhering thereto in the substrate processing apparatus as a cleaning member has been proposed (see Patent Document 2). The method has not only an advantage of the method described in Patent Document 1, but also excellent foreign matter removing performance. Therefore, the method solves the problem in that the operation rate of the substrate processing apparatus decreases and the problem in that a great amount of labor is required for cleaning the substrate processing apparatus.

As described above, the method of cleaning and removing foreign matter with a cleaning member having a pressure-sensitive material is excellent as a method of removing foreign matter effectively. However, this method may cause a problem that the pressure-sensitive material adheres to a cleaning site too strongly to be peeled therefrom, and a problem that a pressure-sensitive adhesive remains at the cleaning site to thereby reversely contaminate the site. There is also a problem that, in the case where the tackiness is decreased for the purpose of preventing an adhesive from remaining, the essential dust-removing property is degraded.

Further, if a method of wiping with a cotton waste impregnated with alcohol (alcohol wiping) is used as a method of removing foreign matter, there is a problem that the foreign matter may remain and the foreign matter may be removed unevenly. Thus, the dust-removing property is degraded.

Recently, the size of minute foreign matter which causes a problem in a substrate and an apparatus that have an aversion to the foreign matter has reached a submicron (1 $\mu$m or less) level. According to the above method, it is difficult to remove the foreign matter of a submicron size exactly.

In order to remove the foreign matter having a particle size of about tens of microns, a cleaning wafer on the surface of which a dot pattern of about tens of microns is formed by a photoresist or cutting/polishing has been proposed (see Patent Document 3). In the cleaning wafer, the foreign matter is held in a space portion of a dot pattern to be removed. Therefore, although foreign matter having a particle size of about tens of microns can be removed, it is difficult to remove minute foreign matter of a submicron size sufficiently.

Patent Document 1: JP 11-87458 A
Patent Document 2: JP 10-154686 A
Patent Document 3: JP 2004-63669 A

Other prior art is disclosed in documents US-2003/124935 and WO 2005/018879.

## DISCLOSURE OF THE INVENTION

PROBLEMS TO BE SOLVED BY THE INVENTION:

An object of the present invention is to provide a cleaning member capable of removing minute foreign matter, or preferably foreign matter of a submicron level simply, exactly, and sufficiently, without contaminating a cleaning site. Another object of the present invention is to provide a delivery member provided with a cleaning function having the cleaning member, and a method of cleaning a substrate processing apparatus with the use of the delivery member provided with a cleaning function.

• MEANS FOR SOLVING THE PROBLEMS:

As the result of intensive studies to solve the above-mentioned problems, the inventors of the present invention have found that the above-mentioned problems can be solved by providing a plurality of protrusions of a columnar structure having an aspect ratio of a particular size on the surface of a cleaning layer provided on the cleaning member, thereby achieving the present invention.
The cleaning member of the present invention is a cleaning member which has a cleaning layer provided with a plurality of protrusions of a columnar structure on the surface as defined in claim 1.
In a preferred embodiment, the length of a protruding portion of the protrusions of a columnar structure is 100 nm or more.
In a preferred embodiment, the density of the protrusions of a columnar structure on the surface of the cleaning layer is $1.0 \times 10^8$ pieces/cm$^2$ or more.
In a preferred embodiment, the cleaning member is used for removing foreign matter on a substrate.
In a preferred embodiment, the cleaning member is used for removing foreign matter in a substrate processing apparatus.
According to another aspect of the present invention, a delivery member with a cleaning function is provided. The delivery member with a cleaning function includes a delivery member and the cleaning member provided on at least one surface of the delivery member.
According to another aspect of the present invention, a method of cleaning a substrate processing apparatus is provided. The method of cleaning a substrate processing apparatus includes delivering the delivery member with a cleaning function into the substrate processing apparatus.

• EFFECTS OF THE INVENTION:

According to the present invention, the cleaning member capable of removing minute foreign matter, in particular foreign matter of a submicron level simply, exactly, and sufficiently without contaminating a cleaning site can be provided. Further, the delivery member provided with a cleaning function having the cleaning member, and the method of cleaning a substrate processing apparatus with the use of the delivery member provided with a cleaning function can be provided.
The effects as described above can be expressed by providing a plurality of protrusions of a columnar structure having an aspect ratio of a particular size on the surface of the cleaning layer provided on the cleaning member. Such effects are considered to be expressed by allowing the cleaning layer provided on the cleaning member to exert a van der Waals attraction between the cleaning layer and a cleaning site.

## BRIEF DESCRIPTION OF THE DRAWINGS

- FIGS. **1** are schematic cross-sectional views of a cleaning member obtained by a preferred embodiment of the present invention.
- FIG. **2** is a schematic cross-sectional view of a delivery member provided with a cleaning function obtained by a preferred embodiment of the present invention.

## DESCRIPTION OF SYMBOLS

**10**      support
**20**      cleaning layer

**50**      delivery member

**100**     cleaning member

**200**     delivery member with a cleaning function

**BEST MODE FOR CARRYING OUT THE INVENTION**

A. Cleaning member:

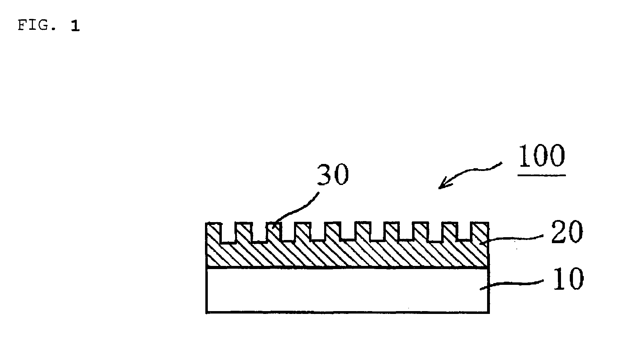

FIG. **1** is a schematic cross-sectional view of a cleaning member that is a preferred embodiment of the present invention. A cleaning member **100** includes a support **10** and a cleaning layer **20**. The support **10** may be omitted depending upon the purpose. More specifically, the cleaning member may be composed of the cleaning layer alone. The cleaning layer **20** includes a plurality of protrusions **30** of a columnar structure on its surface. In the cleaning member of the present invention, in the case where the cleaning layer **20** is provided on the support **10,** the surface on which the cleaning layer **20** is provided may be provided on at least one surface of the support **10**. More specifically, the surface on which the cleaning layer **20** is provided may be provided only on one surface or on both surfaces. Further, the cleaning layer **20** may be provided on an entire surface or only on a part such as an end part of a surface (edge portion).

The protrusions **30** have a columnar structure. The columnar structure according to the present invention includes not only a strictly columnar structure but also a substantially columnar structure. Examples of the columnar structure include a cylindrical structure, a polygonal columnar structure, a cone-shaped structure, and a fiber-shaped structure. Further, the cross-sectional shape of the columnar structure may be uniform or non-uniform over the entire protrusion. Further, the protrusion may protrude along a substantially straight line or along a curved line.

As an angle formed by the protruding direction of the protrusion of a columnar structure and the surface of the cleaning layer, any suitable angle can be adopted as long as the obj ect of the present invention can be achieved. For example, the protrusion of a columnar structure may protrude from the surface of the cleaning layer substantially perpendicularly or may protrude from the surface of the cleaning layer obliquely.

In the present invention, an aspect ratio of the protrusions of a columnar structure is 5 or more. In the present invention, an "aspect ratio" refers to a ratio between a length (A) of a diameter of a portion with the largest diameter of the protrusion of a columnar structure and a length (B) of a protruding portion of the protrusion (it should be noted that the units of (A) and (B) are the same) . In the case where the protrusion of a columnar structure are formed so as to be curved, the length from the surface of the cleaning layer to the portion farthest in a perpendicular direction in the protruding portion of the protrusion is defined as the length of the protruding portion of the protrusions. The aspect ratio of the protrusions of a columnar structure is preferably 6 or more, more preferably 8 or more, and much more preferably 10 or more. The upper limit of the aspect ratio of the protrusions of a columnar structure is preferably 1,000 or less, more preferably 100 or less, and much more preferably 50 or less. When the aspect ratio of the protrusions of a columnar structure is in the above-mentioned range, minute foreign matter, preferably foreign matter of a submicron level can be removed easily, exactly, and sufficiently. It is considered that such an effect can be obtained because of the following: the aspect ratio of the protrusions of a columnar structure is in the above-mentioned range, whereby the Van der Waals attraction is appliedbetween the cleaning layerprovided in the cleaning member and a cleaning site.

The length of the protruding portions of the protrusion of a columnar structure is preferably 100 nm or more, more preferably 200 nm or more, and much more preferably 300 nm or more. The upper limit of the length of the protruding portions of the protrusions of a columnar structure is preferably 100,000 nm, more preferably 10,000 nm or less, and much more preferably 5,000 nm or less. When the length of the protruding portions of the protrusions of a columnar structure is in the above-mentioned range, minute foreign matter, preferably foreign matter of a submicron level can be removed easily, exactly, and sufficiently. It is considered that such an effect can be obtained because of the following: the length of the protruding portions of the protrusions of a columnar structure is in the above-mentioned range, whereby the Van der Waals attraction is appliedbetween the cleaning layer provided in the cleaning member and a cleaning site.

The length of the protruding portions of the protrusions of a columnar structure may be measured by any suitable measurement method. In terms of the ease of measurement and the like, measurement using a scanning electron microscope (SEM) is preferably used. According to the measurement using the scanning electron microscope (SEM), for example, a cleaning layer having a plurality of protrusions of a columnar structure is attached on the surface of a SEM observation sample platform, and the cleaning layer is observed from a side surface direction, whereby the length of the protruding portions of the protrusions of a columnar structure can be determined.

In the present invention, the density of the protrusions of a columnar structure on the surface of the cleaning layer is preferably $1.0 \times 10^8$ pieces/cm$^2$ or more, more preferably $2.0 \times 10^8$ pieces/cm$^2$ or more, and much more preferably $3.0 \times 10^8$ pieces/cm$^2$ or more. The upper limit of the density of the protrusions of a columnar structure on the surface of the cleaning layer is preferably $1.0 \times 10^{12}$ pieces/cm$^2$ or less, more preferably $1.0 \times 10^{11}$ pieces/cm$^2$ or less, and much more preferably $3.0 \times 10^{10}$ pieces/cm$^2$ or less. When the density of the protrusions of a columnar structure on the surface of the cleaning layer is in the above-mentioned range, minute foreign matter, preferably foreign matter of a submicron level can be removed easily, exactly, and sufficiently. It is considered that such an effect can be obtained because of the following: the density of the protrusions of a columnar structure on the surface of the cleaning layer is in the above-mentioned range, whereby the Van der Waals attraction is applied between the cleaning layer provided in the cleaning member and a cleaning site.

In the present invention, the specific surface area of the cleaning layer is preferably 2.0 or more, more preferably 2.2 or more, and much more preferably 2.5 or more. The upper limit of the specific surface area of the cleaning layer is preferably 50 or less, more preferably 30 or less, and much more preferably 10 or less. When the specific surface area of the cleaning layer is in the above-mentioned range, the cleaning layer effectively follows the minute foreign matter present at a site to be cleaned and the unevenness of the site to be cleaned, whereby minute foreign matter, preferably foreign matter of a submicron level can be removed easily, exactly, and sufficiently. It is considered that such an effect can be obtained because of the following: the specific surface area of the cleaning layer is in the above-mentioned range, whereby the Van der Waals attraction is applied between the cleaning layer provided in the cleaning member and a cleaning site.

In the present invention, the "specific surface area of the cleaning layer" refers to a value obtained by dividing the actual surface area of the cleaning layer by an apparent surface area thereof. The actual surface area means the actual surface area based on the increase in a surface area caused by the minute structure formed on the surface of the cleaning layer. The apparent surface area means the surface area determined from an ordinary area calculation expression in the case where the surface of the cleaning layer is assumed to be smooth.

The actual surface area cannot be determined by an ordinary calculation expression for determining an area. Thus, a "BET method" for determining an actual surface area based on an adsorption amount of inactive gas to the surface was used, instead of the measurement of an actual surface area.

According to the BET method, first, a sample is placed in a sample tube (adsorption cell) and the tube is exhausted under vacuum while being heated, and the weight of the sample after degassing is measured. After that, the adsorption cell is attached again to an apparatus, and a gas is fed to the cell. When nitrogen gas adsorbs onto the surface of the sample, and the amount of the gas to be fed is increased, the surface of the sample is covered with gas molecules. Then, the state in which the gas molecules adsorb in a multiplex manner is plotted as changes of the adsorption amount with respect to changes in pressure. The adsorption amount of the gas molecules adsorbing only onto the surface of the sample is determined from the graph by a BET adsorption isotherm represented by Expression (1).

$$P/V \, (P_0 - P) = 1/V_m C + \{(C-1)/V_m C\} \times (P/P_0) \, \dots \, (1)$$

Each symbol in Expression (1) is as follows.

$P$: Pressure of gas of an adsorbate in an adsorption balance
$P_0$: Saturation vapor pressure of an adsorbate at an adsorption temperature.
$V$: Adsorption amount at an adsorption balance pressure P
$V_n$: Adsorption amount of a single molecular layer
$C$: Constant regarding the size of an interaction between a solid surface and an adsorbate, BET constant ($C = \exp\{(E_1 - E_2)/RT\}$
$E_1$: Adsorption heat of a first layer (kJ/mol)
$E_2$: Liquefied heat at a measurement temperature of an adsorbate (kJ/mol)

In the present invention, a flow-type specific surface area automatic measurement apparatus (FlowSorb III 2300, manufactured by Shimadzu Corporation) was used for measuring an actual surface area, and the actual surface area of a sample having a cleaning layer having a minute structure on the surface was measured by the BET method using krypton gas.

In the present invention, as a method of producing the protrusions of a columnar structure on the surface of the cleaning layer, any suitable method can be adopted as long as the object of the present invention can be achieved. Examples of the method include plasma etching, sputtering, a laser treatment, photolithography, and nanoimprint (stamping). The plasma etching is preferably used due to the ease of production and the like.

In the case of forming the protrusions of a columnar structure on the surface of the cleaning layer by the plasma etching, any suitable gas can be adopted as gas species to be used as long as the object of the present invention can be achieved. Examples of the gas include oxygen gas, hydrogen gas, water vapor gas, nitrogen gas, argon gas, and mixed gas of oxygen and water vapor. In particular, the case of using oxygen gas is preferred.

As the gas flow rate in the plasma etching, any suitable gas flow rate can be adopted as long as the object of the present invention can be achieved. For example, the gas flow rate is preferably 0.1 sccm or more, and more preferably 1 sccm or more.

As the vacuum degree gas pressure in the plasma etching, any suitable vacuum degree gas pressure can be adopted as long as the object of the present invention can be achieved. For example, the vacuum degree gas pressure is preferably 100 Pa or less, and more preferably 50 Pa or less.

As the surface treatment conditions in the plasma etching, any suitable conditions can be adopted as long as the object of the present invention can be achieved. For example, the discharge power energy represented by the product of the discharge power density and the treatment time is preferably 100 W•sec/cm$^2$ or more, and more preferably 250 W•sec/cm$^2$ or more. The distance between electrodes is preferably 0.1 mm to 1 m. The power source is preferably RF. The discharge power density is preferably 0.01 W/cm$^2$ or more, and more preferably 0.1 W/cm$^2$ or more. The treatment time is preferably 60 seconds or more, and more preferably 300 seconds or more.

The tensile modulus of elasticity of the cleaning layer is preferably 0.5 MPa or more, more preferably 1 to 10,000 MPa, and much more preferably 10 to 10,000 MPa in a use temperature region of the cleaning member. If the tensile modulus of elasticity is in such a range, a cleaning member excellent in the balance between the foreign matter removability and the delivery property is obtained. The tensile modulus of elasticity is measured in accordance with JIS K7127. By setting the tensile modulus of elasticity of the cleaning layer in the above range, minute foreign matter, preferably foreign matter of a submicron level can be removed simply, exactly, and sufficiently.

The 180° peeling tackiness of the cleaning layer with respect to, for example, the mirror surface of a silicon wafer is preferably 0.2 N/10 mm width or less and more preferably 0.01 to 0.10 N/10 mm width. In such a range, the cleaning layer has satisfactory foreign matter removability and a delivery property. The 180° peeling tackiness is measured in accordance with JIS Z0237.

Regarding the thickness of the cleaning layer, any suitable conditions can be adopted in a range in which the object of the present invention can be achieved. The thickness of the cleaning layer is preferably 1 to 200 µm, more preferably 5 to 100 µm, much more preferably 5 to 50 µm, and particularly preferably 5 to 20 pm. In such a range, minute foreign matter, preferably foreign matter of a submicron level can be removed simply, exactly, and sufficiently.

The cleaning layer substantially does not preferably have tackiness. Herein, having substantially no tackiness means that there is not pressure-sensitive tackiness typifying the function of tackiness, when the nature of the tackiness is assumed to be the friction that is a resistance to slippery. The pressure-sensitive tackiness is expressed in the range of up to 1 MPa of the modulus of elasticity of a pressure-sensitive material in accordance with Dahlquist, for example.

Any suitable material may be employed as a material forming the above-mentioned cleaning layer as long as the object of the present invention can be accomplished. Specific examples of the material forming the cleaning layer include: a polymer resin such as a polyimid-based resin, a polyester-based resin, a fluorine-based resin, an acrylic-based resin, an epoxy-based resin, a polyolefin-based resin, polyvinylchloride, EVA, PEEK, PMMA, or POM. In particular, the polyimid-based resin and polyester-based resin are preferably used because of their good heat resistance.

The material forming the cleaning layer further can contain any suitable additive in a range in which the object of the present invention can be achieved. Specific examples of the additive include a surfactant, aplasticizer, an antioxidant, a conductivity providing material, a UV-absorber, and a light stabilizer. By adjusting the kind and/or the amount of an additive to be used, a cleaning layer having desired properties in accordance with the purpose can be obtained.

The cleaning layer may be formed by any suitable method in a range in which the object of the present invention can be achieved. Examples of the method of forming a cleaning layer include a method of forming a cleaning layer as a single layer film, a method of applying a resin to a support, and a method of attaching a resin layer separately formed to a support. More specific examples include a method of using a single layer film, a method of directly applying a cleaning layer to a support (e.g., the delivery member) such as a silicon wafer by a spin-coating method or spraying method, and a method of forming a cleaning layer by applying it to a PET film or a polyimide film by a comma coating method, a fountain method, a gravure method, or the like.

As the support, any suitable support can be adopted as long as it can support the cleaning layer. As the thickness of the support, any suitable thickness can be adopted as long as the object of the present invention can be achieved. The thickness of the support is preferably 500 µm or less, more preferably 3 to 300 µm, and most preferably 5 to 250 µm.

The surface of the support may be subjected to conventional surface treatment, e.g., chemical or physical treatment such as chromic acid treatment, ozone exposure, flame exposure, high-pressure electrical-shock exposure, and ionized radiation treatment, or application treatment with an undercoating agent (e.g., the above adherent material) in order to enhance the adhesion with respect to an adjacent layer, a retention property, and the like. The support may be a single layer or a multilayered body.

As the material for the support, any suitable material is adopted according to the purpose as long as the object of the present invention is achievable. Examples of the material for the support include an engineering plastic film and a super engineering plastic film. Specific examples of the engineering plastic and the super engineering plastic include polyimide, polyethylene, polyethylene terephthalate, acetyl cellulose, polycarbonate, polypropylene, and polyamide. As physical properties such as a molecular weight, any appropriate physical properties can be adopted as long as the object of the present invention is achievable. As a method of forming the support, any appropriate method can be adopted as long as the object of the present invention is achievable.

The cleaning layer may typically have a protective film attached thereto preliminarily, and the film can be peeled at an appropriate stage such as during application. The protective film can be typically used for the purpose of protecting the cleaning layer when the cleaning layer is formed or the cleaning layer is attached (crimped) to the support.

Any appropriate film may be employed as the appropriate protective film as long as the object of the present invention can be accomplished. Examples of the protective film include: plastic films made of polyolefins such as polyethylene, polypropylene, polybutene, polybutadiene, and polymethylpentene, polyvinyl chloride, a vinyl chloride copolymer, polyethylene terephthalate, polybutylene terephthalate, polyurethane, an ethylene vinyl acetate copolymer, an ionomer resin, an ethylene (meth)acrylic acid copolymer, an ethylene (meth)acrylate copolymer,polystyrene,and polycarbonate;a polyimidefilm; and a fluorine resin film.

It is preferred that the protective film be subjected to a releasing treatment with a releasing treatment agent in accordance with the purpose. Examples of the releasing treatment agent include a silicone-based compound, alongchain alkyl-based compound, a fluorine-based compound, an aliphatic acid amide-based compound, and a silica-based compound. The silicone-based compound is particularly preferred.

Polyolefin resin-based films such as polyethylene, polypropylene, polybutene, polybutadiene, and polymethylpentene films exhibit a releasing property with no releasing treatment agent being used. Thus, those films may also be used alone as a protective film.

The protective film has a thickness of preferably 1 to 100 $\mu$m, or more preferably 10 to 100 $\mu$m. As a method of forming the protective film, any suitable method may be adopted as long as the object of the present invention can be accomplished. For instance, an injection moldingmethod, anextrusionmoldingmethod, orablowmolding method can be used to form the film.

As the application of the cleaning member of the present invention, any suitable application can be adopted in the range of the object of the present invention. Preferably, the cleaning member is used for removing foreign matter on a substrate and removing foreign matter in a substrate processing apparatus. More specifically, the cleaning member is used preferably for cleaning a substrate processing apparatus that has an aversion to minute foreign matter, such as a production apparatus and an inspection apparatus of a semiconductor, a flat panel display, and a printed board. As a delivery member used for cleaning by being delivered in a substrate processing apparatus, any suitable delivery member can be adopted in the range of the object of the present invention. Specifically, examples include a substrate for a flat panel display such as a semiconductor wafer, an LCD, or a PDP, and a substrate for a compact disk, an MR head, or the like.

In the present invention, there is no particular limit to a substrate processing apparatus in which dust-removing is performed, and examples of the substrate processing apparatus include an exposure apparatus, a resist applying apparatus, a developing apparatus, an ashing apparatus, a dry etching apparatus, an ion implantation apparatus, a PVD apparatus, a CVD apparatus, an outer appearance inspection apparatus, and a wafer prober.

B. Delivery member provided with a cleaning function:

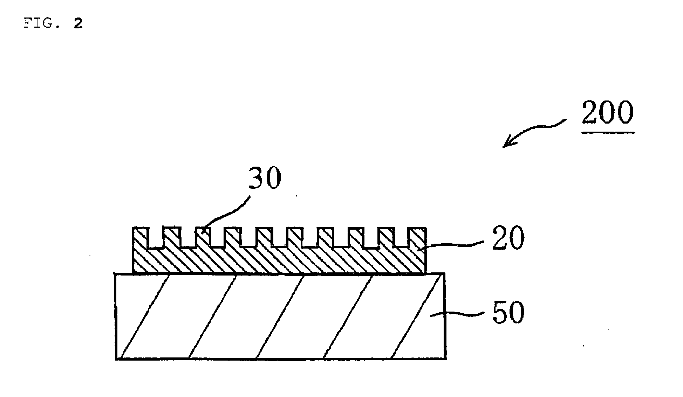

FIG. **2** is a schematic cross-sectional view of a delivery member provided with a cleaning function in the present invention. As shown in FIG. **2,** the delivery member provided with a cleaning function **200** includes a delivery member **50** and a cleaning layer **20** at least on one surface (one surface in the illustrated example) of the delivery member **50.** Specifically, in this embodiment, the cleaning layer **20** is formed directly on the delivery member **50.** Such a delivery member provided with a cleaning function is delivered in an apparatus and is brought into contact with and moved to a site to be cleaned, whereby foreign matter can be cleaned and removed simply and exactly without causing any delivery trouble due to the foreign matter adhering to the inside of the apparatus.

As the delivery member **50,** any suitable substrate is used depending upon the kind of a substrate processing apparatus from which foreign matter is to be removed. Specific examples of the substrate include a substrate for a flat panel display such as a semiconductor wafer (e.g., asiliconwafer), an LCD, ora PDP, and a substrate for a compact disk, an MR head, or the like.

Regarding the cleaning layer **20** in the delivery member provided with a cleaning function, the description of the cleaning layer in the A item can be adopted.

The delivery member provided with a cleaning function may be produced with a cleaning sheet attached to a delivery member or with a cleaning layer directly provided on at least one surface of the delivery member. More specifically, the cleaning layer may be formed by a method of applying a curable resin composition or a polymer resin having heat resistance described in the A item as a material for the cleaning layer, curing the resin composition or the polymer resin with an active energy source, or drying the resin composition or the polymer resin, followed by heat-treatment at a high temperature. After forming or in the course of forming the cleaning layer, preferably the protective film described in the A item is attached on the cleaning layer.

<u>C</u>. Cleaning method:

The cleaning method in the present invention includes delivering the delivery member provided with a cleaning function of the present invention into a substrate processing apparatus. The delivery member provided with a cleaning function of the present invention is delivered into a desired substrate processing apparatus, and brought into contact with a site to be cleaned, whereby foreign matter adhering to the site to be cleaned can be cleaned and removed simply and exactly.

There is no particular limit to the substrate processing apparatus to be cleaned by the cleaning method. Specific examples of the substrate processing apparatus include not only the apparatuses described herein but also various kinds of production apparatuses and inspection apparatuses such as an exposure irradiation apparatus for forming a circuit, a resist application apparatus, a sputtering apparatus, an ion implantation apparatus, a dry etching apparatus, and a wafer prober, and substrate processing apparatuses, which are used at high temperature, such as an ozone asher, aresistcoater, an oxidation diffusion furnace, an ordinary pressure CVD apparatus, a reduced-pressure CVD apparatus, and a plasma CVD apparatus.

Examples:

Hereinafter, the present invention will be described more specifically by way of examples. However, the present invention is not limited to these examples. Further, "parts" in the examples are based on the weight.

[Specific surface area of cleaning layer]

The actual surface area was measured using krypton gas as an adsorption gas by a flow-type specific surface area automatic measurement apparatus (FlowSorb III 2300, manufactured by Shimadzu Corporation).

Regarding the cleaning layer having protrusions of a columnar structure on the surface, the specific surface area was determined by Expression (2):

$$S_X = S_A/S_B \ ... \ (2)$$

$S_X$: specific surface area
$S_A$: actual surface area of one surface of a sample ({actual surface area of both surfaces of a sample - (actual surface area of both surfaces of an untreated sample/2)})
$S_B$: apparent surface area of one surface of a sample.

On the other hand, regarding the cleaning layer having no protrusions of a columnar structure on the surface, a specific surface area was obtained by Expression (3):

$$S_X = S_A/S_B \ ... \ (3)$$

$S_X$: specific surface area
$S_A$: actual surface area of one surface of a sample (actual surface area of both surfaces of a sample/2)
$S_B$: apparent surface area of one surface of a sample.

[Density of protrusions of columnar structure on surface of cleaning layer]

The density of the protrusions of a columnar structure on the surface of the cleaning layer was measured by counting the number of the protrusions of a columnar structure on a 1 $cm^2$ surface of the cleaning layer.

[Aspect ratio of protrusions of columnar structure]

The aspect ratio of the protrusions of a columnar structure on the surface of the cleaning layer was measured by SEM by observing the cleaning layer from a side.

[Length of protruding portions of protrusions of columnar structure]

The length of the protruding portions of the protrusions of a columnar structure on the surface of the cleaning layer was measured by SEM by observing the cleaning layer from a side.

[Dust-removing property]

The dust-removing property was evaluated by the following method. More specifically, silicon powders with an average particle size of 0.5 $\mu$m were allowed to adhere uniformly onto a 8-inch silicon wafer so that the number of particles reached about 10,000. Then, a polymer resin film having the cleaning layer provided with protrusions of a columnar structure on the surface was cut to pieces each having a size of 10 cm $\times$ 10 cm, and the cleaning layer was brought into contact with the 8-inch silicon wafer with the silicon powders adhering thereto for one minute. After two minutes, the activated film was removed, and the number of silicon powder particles of 0.5 $\mu$m was measured by a particle counter (SurfScan-6200, manufactured by KLA tencor Corporation) to calculate a dust-removing ratio. The measurement was performed three times, and the average thereof was determined.

[Example 1]

A polyimide film (Apical NPI25-NPS, manufactured by Kaneka Corporation) was cut to a piece having an apparent surface area of 100 cm$^2$, and one surface of the cut film was subjected to oxygen plasma etching (A) to produce a cleaning layer having a plurality of protrusions of a columnar structure on the surface.
The oxygen plasma etching (A) is plasma etching with oxygen gas, and was performed under the following conditions: a distance between electrodes of a plasma generation apparatus of 10 cm, an RF power source, an oxygen gas flow rate of 300 sccm, a discharge power density of 0.78 W/cm$^2$, a treatment time of 600 seconds, and a discharge power energy of 468 W•sec/cm$^2$.
The obtained cleaning layer was measured for the specific surface area of the cleaning layer, the density of protrusions of a columnar structure on the surface of the cleaning layer, the aspect ratio of the protrusions of a columnar structure, the length of protruding portions of the protrusions of a columnar structure, and a dust-removing property. Table 1 shows the results.

[Example 2]

A polyimide film (Apical NPI25-NPS, manufactured by Kaneka Corporation) was cut to a piece having an apparent surface area of 100 cm$^2$, and one surface of the cut film was subjected to oxygen plasma etching (B), whereby a cleaning layer having a plurality of protrusions of a columnar structure on the surface was produced.
The oxygen plasma etching (B) is plasma etching with oxygen gas, and was performed under the following conditions: a distance between electrodes of a plasma generation apparatus of 10 cm, an RF power source, an oxygen gas flow rate of 300 sccm, a discharge power density of 0.78 W/cm$^2$, a treatment time of 300 seconds, and a discharge power energy of 234 W•sec/cm$^2$.
The obtained cleaning layer was measured for the specific surface area of the cleaning layer, the density of protrusions of a columnar structure on the surface of the cleaning layer, the aspect ratio of the protrusions of a columnar structure, the length of protruding portions of the protrusions of a columnar structure, and a dust-removing property. Table 1 shows the results.

[Example 3]

A polyimide film (Apical NPI25-NPS, manufactured by Kaneka Corporation) was cut to a piece having an apparent surface area of 100 cm$^2$, and one surface of the cut film was subjected to oxygen plasma etching (C), whereby a cleaning layer having a plurality of protrusions of a columnar structure on the surface was produced.
The oxygen plasma etching (C) is plasma etching with oxygen gas, and was performed under the following conditions: a distance between electrodes of a plasma generation apparatus of 10 cm, an RF power source, an oxygen gas flow rate of 20 sccm, a discharge power density of 0.07 W/cm$^2$, a treatment time of 6,600 seconds, and a discharge power energy of 462 W•sec/cm$^2$.
The obtained cleaning layer was measured for the specific surface area of the cleaning layer, the density of protrusions of a columnar structure on the surface of the cleaning layer, the aspect ratio of the protrusions of a columnar structure, the length of protruding portions of the protrusions of a columnar structure, and a dust-removing property. Table 1 shows the results.

[Comparative Example 1]

A polyimide film (Apical NPI25-NPS, manufactured by Kaneka Corporation) was cut to a piece having an apparent surface area of 100 cm$^2$, and one surface of the cut film was subjected to oxygen plasma etching (D), whereby a cleaning layer having a plurality of protrusions of a columnar structure on the surface was produced.

The oxygen plasma etching (D) is plasma etching with oxygen gas, and was performed under the following conditions: a distance between electrodes of a plasma generation apparatus of 10 cm, an RF power source, an oxygen gas flow rate of 300 sccm, a discharge power density of 0.78 W/cm$^2$, a treatment time of 60 seconds, and a discharge power energy of 47 W·sec/cm$^2$.

The obtained cleaning layer was measured for the specific surface area of the cleaning layer, the density of protrusions of a columnar structure on the surface of the cleaning layer, the aspect ratio of the protrusions of a columnar structure, the length of protruding portions of the protrusions of a columnar structure, and a dust-removing property. Table 1 shows the results.

[Comparative Example 2]

A polyimide film (Apical NPI25-NPS, manufactured by Kaneka Corporation) was cut to a piece having an apparent surface area of 100 cm$^2$ to produce a cleaning layer.

The obtained cleaning layer was measured for the specific surface area of the cleaning layer, the density of protrusions of a columnar structure on the surface of the cleaning layer, the aspect ratio of the protrusions of a columnar structure, the length of protruding portions of the protrusions of a columnar structure, and a dust-removing property. Table 1 shows the results.

[Table 1]

|  | Example 1 | Example 2 | Example 3 | Comparative Example 1 | Comparative Example 2 |
|---|---|---|---|---|---|
| Specific surface area | .8 | .7 | .8 | .9 | .7 |
| Density (pieces / cm$^2$) | .2 × 10$^8$ | .6 × 10$^8$ | .6 × 10$^{10}$ | .0 × 10$^{10}$ | .A |
| Aspect ratio | 5 | 2 | 0 |  | .A |
| Length of protruding portion (nm) | ,500 | 00 | 00 | 0 |  |
| Dust-removing property (%) | 00 | 0 | 0 |  |  |

As is understood from Table 1, an excellent dust-removing property was shown in Examples 1 to 3, whereas a sufficient dust-removing property was not obtained in Comparative Examples 1 and 2.

**INDUSTRIAL APPLICABILITY**

The cleaning member and the delivery member with a cleaning function of the present invention are preferably used for cleaning substrate processing apparatuses such as various kinds of production apparatuses and inspection apparatuses.

**Claims**

**1.** A cleaning member (100) comprising a cleaning layer (20) having a plurality of protrusions (30) of a columnar structure on a surface, wherein an aspect ratio of each of the protrusions of a columnar structure is 5 or more, and a specific surface area of the cleaning layer is 2.0 or more,
said aspect ratio being the ratio between a length (A) of a diameter of a portion with the largest diameter of the protrusion of a columnar structure and a length (B) of a protruding portion of the protrusion,
and said specific surface area being obtained by dividing the actual surface area of the cleaning layer by an apparent surface area thereof, the actual surface area being the actual surface area based on the increase in a surface area caused by a minute structure formed on the surface of the cleaning layer, and the apparent surface area being the surface area in the case the surface of the cleaning layer is assumed to be smooth.

**2.** A cleaning member according to claim 1, wherein a length of a protruding portion of each of the protrusions of a columnar structure is 100 nm or more.

**3.** A cleaning member according to claim 1 or 2, wherein a density of each of the protrusions of a columnar structure on the surface of the cleaning layer is $1.0 \times 10^8$ pieces/cm$^2$ or more.

**4.** Use of a cleaning member according to any one of claims 1 to 3, for removing foreign matter on a substrate.

**5.** Use of a cleaning member according to any one of claims 1 to 3, for removing foreign matter in a substrate processing apparatus.

**6.** Use according to claim 5, wherein said cleaning member is provided on at least one surface of a delivery member (50).

**7.** A method of cleaning a substrate processing apparatus, comprising delivering a delivery member (200) with a cleaning function into the substrate processing apparatus, said delivery member comprising a cleaning member according to any of claims 1 to 3, provided on a delivery member (50).


**Patentansprüche**

**1.** Reinigungselement (100), das eine Reinigungsschicht (20) mit einer Vielzahl von Vorsprüngen (30) in Säulenform an einer Oberfläche umfasst, wobei ein Seitenverhältnis jedes der Vorsprünge in Säulenform 5 oder mehr beträgt und eine spezifische Oberfläche der Reinigungsschicht 2.0 oder mehr beträgt,
wobei das Seitenverhältnis das Verhältnis zwischen einer Länge (A) eines Durchmessers eines Abschnitts des Vorsprungs in Säulenform mit dem größten Durchmesser und einer Länge (B) eines vorstehenden Abschnitts des Vorsprungs ist, und
die spezifische Oberfläche ermittelt wird, indem die tatsächliche Flächenausdehnung der Reinigungsschicht durch eine scheinbare Flächenausdehnung derselben dividiert wird, wobei die tatsächliche Flächenausdehnung die tatsächliche Flächenausdehnung auf Basis der Vergrößerung einer Flächenausdehnung ist, die durch kleinste Strukturen bewirkt wird, die an der Oberfläche der Reinigungsschicht ausgebildet sind, und die scheinbare Flächenausdehnung die Flächenausdehnung für den Fall ist, dass angenommen wird, dass die Oberfläche der Reinigungsschicht glatt ist.

**2.** Reinigungselement nach Anspruch 1, wobei eine Länge eines vorstehenden Abschnitts jedes der Vorsprünge in Säulenform 100 nm oder mehr beträgt.

**3.** Reinigungselement nach Anspruch 1 oder 2, wobei eine Dichte jedes der Vorsprünge in Säulenform an der Oberfläche der Reinigungsschicht $1{,}0 \times 10^8$ Teile/cm$^2$ oder mehr beträgt.

**4.** Einsatz eines Reinigungselementes nach einem der Ansprüche 1 bis 3 zum Entfernen von Fremdkörpern von einem Substrat.

**5.** Einsatz eines Reinigungselementes nach einem der Ansprüche 1 bis 3 zum Entfernen von Fremdkörpern in einer Substrat-Bearbeitungsvorrichtung.

**6.** Einsatz nach Anspruch 5, wobei das Reinigungselement an wenigstens einer Fläche eines Zuführelementes (50) vorhanden ist.

**7.** Verfahren zum Reinigen einer Substrat-Bearbeitungsvorrichtung, das Zuführen eines Zuführelementes (200) mit einer Reinigungsfunktion in die Substrat-Bearbeitungsvorrichtung umfasst, wobei das Zuführelement ein Reinigungselement nach einem der Ansprüche 1 bis 3 umfasst, das auf einem Zuführelement (50) vorhanden ist.


**Revendications**

**1.** Organe de nettoyage (100) comprenant une couche de nettoyage (20) ayant une pluralité de protubérances (30) de structure colonnaire sur une surface, dans lequel un rapport d'aspect de chacune des protubérances d'une structure colonnaire est de 5 ou plus, et une superficie spécifique de la couche de nettoyage est de 2, 0 ou plus,

ledit rapport d'aspect étant le rapport entre une longueur (A) d'un diamètre d'une portion ayant le plus grand diamètre de la protubérance d'une structure colonnaire et une longueur (B) d'une portion protubérante de la protubérance, et ladite superficie spécifique étant obtenue en divisant la superficie réelle de la couche de nettoyage par une superficie apparente de cette dernière, la superficie réelle étant la superficie réelle basée sur l'augmentation d'une superficie causée par une structure minuscule formée sur la surface de la couche de nettoyage, et la superficie apparente étant la superficie dans le cas où l'on suppose que a surface de la couche de nettoyage est lisse.

2. Organe de nettoyage selon la revendication 1, dans lequel une longueur d'une portion protubérante de chacune des protubérances d'une structure colonnaire est de 100 nm ou plus.

3. Organe de nettoyage selon la revendication 1 ou 2, dans lequel une densité de chacune des protubérances d'une structure colonnaire sur la surface de la couche de nettoyage est de $1,0 \times 10^8$ protubérances/cm$^2$ ou plus.

4. Utilisation d'un organe de nettoyage selon l'une quelconque des revendications 1 à 3, pour éliminer de la matière étrangère sur un substrat.

5. Utilisation d'un organe de nettoyage selon l'une quelconque des revendications 1 à 3, pour éliminer de la matière étrangère dans un appareil de traitement de substrat.

6. Utilisation selon la revendication 5, dans laquelle ledit organe de nettoyage est agencé sur au moins une surface d'un organe de distribution (50).

7. Procédé de nettoyage d'un appareil de traitement de substrat, comprenant les étapes consistant à fournir un organe de distribution (200) ayant une fonction de nettoyage dans l'appareil de traitement de substrat, ledit organe de distribution comprenant un organe de nettoyage selon l'une quelconque des revendications 1 à 3, agencé sur un organe de distribution (50).

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11087458 A
- JP 10154686 A
- JP 2004063669 A
- US 2003124935 A
- WO 2005018879 A